(19) Europäisches Patentamt
European Patent Office
Office européen des brevets

(11) **EP 1 410 503 B1**

(12) **EUROPÄISCHE PATENTSCHRIFT**

(45) Veröffentlichungstag und Bekanntmachung des Hinweises auf die Patenterteilung:
**09.02.2005 Patentblatt 2005/06**

(51) Int Cl.$^7$: **H03H 9/17**

(21) Anmeldenummer: 02748734.7

(86) Internationale Anmeldenummer:
**PCT/EP2002/006144**

(22) Anmeldetag: **04.06.2002**

(87) Internationale Veröffentlichungsnummer:
**WO 2003/012988 (13.02.2003 Gazette 2003/07)**

(54) **PIEZOELEKTRISCHE RESONATORVORRICHTUNG MIT AKUSTISCHEM REFLEKTOR**

PIEZOELECTRIC RESONATOR DEVICE COMPRISING AN ACOUSTIC REFLECTOR

DISPOSITIF RESONATEUR PIEZO-ELECTRIQUE A REFLECTEUR ACOUSTIQUE

(84) Benannte Vertragsstaaten:
**DE FR GB IT**

(30) Priorität: **30.07.2001 DE 10137129**

(43) Veröffentlichungstag der Anmeldung:
**21.04.2004 Patentblatt 2004/17**

(73) Patentinhaber: **Infineon Technologies AG**
**81669 München (DE)**

(72) Erfinder:
- **AIGNER, Robert**
  **81675 München (DE)**
- **ELBRECHT, Lueder**
  **81825 München (DE)**
- **MARKSTEINER, Stephan**
  **85640 Putzbrunn (DE)**
- **TIMME, Hans-Joerg**
  **85521 Ottobrunn (DE)**

(74) Vertreter: **Zinkler, Franz, Dipl.-Ing.**
**Schoppe, Zimmermann, Stöckeler & Zinkler**
**Postfach 246**
**82043 Pullach bei München (DE)**

(56) Entgegenhaltungen:
**US-A- 4 166 967          US-A- 5 821 833**

- **NAIK R S ET AL: "Measurements of the bulk, C-axis electromechanical coupling constant as a function of AIN film quality" IEEE TRANSACTIONS ON ULTRASONICS, FERROELECTRICS AND FREQUENCY CONTROL, IEEE INC. NEW.YORK, US, Bd. 47, Nr. 1, Januar 2000 (2000-01), Seiten 292-296, XP002184425 ISSN: 0885-3010 in der Anmeldung erwähnt**

EP 1 410 503 B1

**Beschreibung**

Die vorliegende Erfindung bezieht sich auf eine Resonatorvorrichtung, insbesondere auf eine Resonatorvorrichtung mit einem piezoelektrischen Resonator und einem zugeordneten akustischen Reflektor.

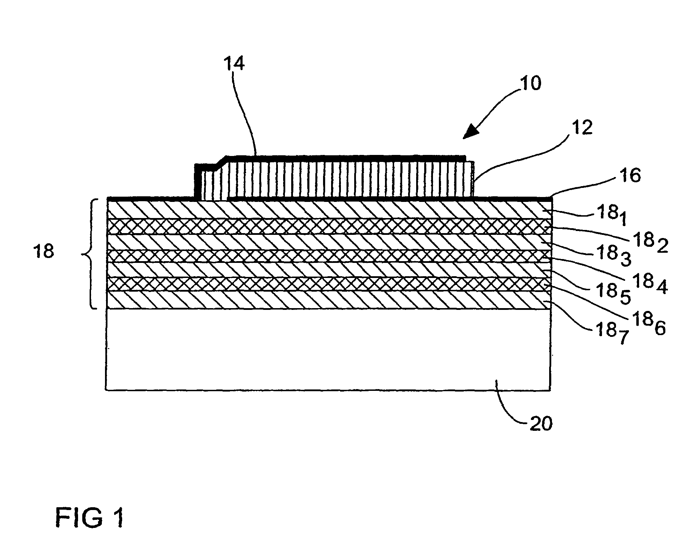

In Fig. 1 ist beispielhaft eine Resonatorvorrichtung gezeigt, welche einen piezoelektrischen Resonator 10 umfasst. Der piezoelektrische Resonator 10 umfasst eine piezoelektrische Schicht 12 sowie eine erste Elektrode 14 und eine zweite Elektrode 16. Benachbart zu dem piezoelektrischen Resonator 10 ist ein akustischer Bragg-Reflektor 18 angeordnet, der eine Mehrzahl von Schichten $18_1$ bis $18_7$ umfasst. Ferner ist ein Substrat 20 vorgesehen. Der Reflektor 18 ist zwischen dem -Substrat 20 und dem piezoelektrischen Resonator 10 angeordnet. Die Schichten $18_1$, $18_3$, $18_5$ und $18_7$ des akustischen Reflektors sind Schichten mit niedriger akustischer Impedanz, und die Schichten $18_2$, $18_4$, und $18_6$ sind Schichten mit hoher akustischen Impedanz.

Bei piezoelektrischen Dünnfilmresonatoren (TFBAR = Thin Film Bulk Acoustic Wave Resonator = akustischer Volumenwellen-Dünnfilm-Resonatoren, oder FBAR = Film Bulk Acoustic Wave Resonator = akustischer Volumenwellen-Film-Resonator, BAW = Bulk Acoustic Wave = akustische Volumenwelle) muss zur Gewährleistung der Funktionalität die in der piezoelektrischen Schicht (Piezoschicht - siehe Bezugszeichen 12 in Fig. 1) angeregte Schallwelle vom Substrat 20 - über dem das Bauelement aufgebaut ist - akustisch isoliert werden.

Im Stand der Technik sind für die Isolierung folgende zwei Verfahren bekannt. Das erste Verfahren besteht darin, dass das Substrat 20 bzw. eine geeignete Opferschicht unter dem Bauelement entfernt wird. In diesem Fall bildet der Resonator eine dünne, freitragende Struktur (Membran oder Brücke). Der Nachteil dieser Vorgehensweise besteht darin, dass die sich ergebende Struktur sehr empfindlich und schwierig weiterzuverarbeiten ist, insbesondere was die Gehäusung einer solchen Struktur (Packaging) betrifft.

Das zweite Verfahren zur akustischen Isolierung des Bauelements von dem Substrat 20 ist in Fig. 1 gezeigt, bei dem das Bauelement auf dem akustischen Bragg-Reflektor 18 aufgebaut ist. Wie erwähnt, besteht dieser aus einer Abfolge von Schichten $18_1$ bis $18_7$ mit wechselweise hoher und niedriger akustischer Impedanz. Hinsichtlich der in Fig. 1 gezeigten Struktur wird auf das US-Patent 4,166,967 sowie auf den Artikel von K. Lakin in Appl. Phys. Lett. 38, 1981, S. 125-127 verwiesen. Ferner wird auf den Artikel von G.D. Mansfeld und S.G. Alekseev, in Ultrasonics Symp. Proc., Band 2, 1997, S. 891-894 verwiesen.

Bei piezoelektrischen Resonatoreinrichtungen, wie sie beispielsweise anhand der Fig. 1 beschrieben sind, liegt die optimale Schichtdicke der einzelnen Schichten für eine vorgegebenen Betriebsfrequenz $f_o$ bei einem Viertel der akustischen Wellenlänge $\lambda_{ac}$ im Material bzw. in der Schicht, die optimale Schichtdicke ergibt sich gemäß der nachfolgenden Bedingung (1) zu:

$$d_{opt} = \frac{\lambda_{ac}}{4} = \frac{v_{ac}}{4 \cdot f_0} = \frac{Z_{ac}}{\rho \cdot 4 \cdot f_0} \qquad (1)$$

mit:

$V_{ac}$ = Schallgeschwindigkeit in der betrachteten Schicht,

$Z_{ac}$ = akustische Impedanz der betrachteten Schicht, und

$\rho$ = Dichte des Materials der betrachteten Schicht.

Der Vorteil der Verwendung des akustischen Bragg-Reflektors besteht darin, dass die unter Verwendung dieses Reflektors hergestellten Resonatoren eine hohe mechanische Stabilität aufweisen. Die vorliegende Erfindung bezieht sich ebenfalls auf diese Art der akustischen Entkopplung.

Typische Materialien mit hoher akustischer Impedanz sind Metalle wie z. B. Wolfram (W), Platin (Pt), Molybdän (Mo) oder Gold (Au). Materialien mit niedriger akustischer Impedanz sind beispielsweise Siliziumdioxid ($SiO_2$) oder Aluminium (Al).

Bei der Realisierung der in Fig. 1 gezeigten Bragg-Reflektoren 18 kann es in mehrfacher Hinsicht zu den nachfolgend dargelegten Problemen kommen.

Zum einen kann die Realisierung der oben erwähnten Schichtdicken $d_{opt}$ aus technologischen Gründen problematisch sein. Ein Beispiel hierfür ist die Begrenzung der realisierbaren Schichtdicken aufgrund von Schichtspannungen, die bei der Abscheidung bzw. der Erzeugung dieser Schichten entstehen, so dass die Schichtdicke eine maximale Dicke nicht überschreiten darf. Bei Metallen, wie z. B. Wolfram, Platin oder Molybdän tritt dieses Problem auf. Für einen 900 MHz-Dünnfilmresonator (Betriebsfrequenz = 900 MHz) liegt die optimale Dicke für Wolfram bei $d_w$ = 1,4 μm, bei Platin bei $d_{Pt}$ = 0,85 μm und bei Molybdän bei $d_{Mo}$ = 1,6 μm. Solche dicken Metallschichten sind technologisch nur schwer zu realisieren.

Ein weiteres Problem stellen die parasitären Kapazitäten in dem Bauelement zum Substrat hin dar. Für dielektrische Schichten im Bragg-Reflektor, wie beispielsweise $SiO_2$ ist daher aus elektrischen Gründen (Minimierung der parasitären Kapazitäten zum Substrat hin) eine Maximierung der Schichtdicke wünschenswert. Entsprechend dicke dielektrische Schichten stehen jedoch im Widerspruch zu der obigen Bedingung (1), da die Schichtdicke in diesem Fall über die optimale Schichtdicke hinausgeht.

Ein weiteres Problem stellen die unterschiedlichen Temperaturkoeffizienten der Schichten $18_1$ bis $18_7$ dar. Die Temperaturkoeffizienten der verwendeten Schichten haben einen Einfluss auf das Temperaturverhalten des Dünnfilm-Resonators. Für den Fall, dass die Materialien für die Schichten mit hoher akustischer Impedanz und für die Schichten mit niedriger akustischer Impedanz Temperaturkoeffizienten mit unterschiedlichen Vorzeichen haben, lässt sich im allgemeinen eine Schichtdickenkombination mit minimalem Temperaturkoeffizienten des Dünnfilm-Resonators finden, jedoch haben die Schichten dann Dicken die nicht der optimalen Schichtdicke entsprechen, so dass eine solche Schichtdickenkombination im allgemeinen im Widerspruch zu der obigen Bedingung (1) steht.

Im Stand der Technik sind zwar Realisierungen von Dünnschichtresonatoren, wie sie in Fig. 1 gezeigt sind, bekannt, bei denen der akustische Reflektor mittels Schichten aufgebaut ist, die der obigen Bedingung (1) hinsichtlich der Schichtdicke genügen. Dies führt jedoch zu einer unerwünschten Einschränkung der Auswahl der verwendbaren Materialien und der erreichbaren Frequenzbereiche. Verwendet man beispielsweise Aluminiumnitrid (AlN) als Material mit hoher akustischer Impedanz und $SiO_2$ als Material mit niedriger akustischer Impedanz, wie dies von R. S. Naik u.a. in IEEE Trans. Ultrasonics, Ferroelectrics, und Freq. Control, 47 (1), 2000, S. 292-296 beschrieben wird, so lässt sich das obige Problem im Zusammenhang mit den parasitären Kapazitäten vermeiden. Da es sich bei den beiden genannten Materialien um Dielektrika handelt, tritt dieses Problem nicht auf. Allerdings ist bei dieser Materialkombination der Unterschied zwischen den akustischen Impedanzen vergleichsweise klein, worunter die Güte des Bragg-Reflektors leidet, und bei gleicher Anzahl von Schichten deutlich niedriger ist als bei Bragg-Reflektoren, die eine der oben genannten Metallschichten als Material mit hoher akustischer Impedanz verwenden.

Ausgehend von diesem Stand der Technik liegt der vorliegenden Erfindung die Aufgabe zugrunde, eine verbesserte Resonatorvorrichtung zu schaffen, bei der die oben genannten Probleme in Zusammenhang mit der Herstellung von dicken Schichten, im Zusammenhang mit parasitären Kapazitäten und mit unterschiedlichen Temperaturkoeffizienten minimiert oder vermieden werden können.

Diese Aufgabe wird durch eine Resonatorvorrichtung gemäß Anspruch 1 gelöst.

Die vorliegende Erfindung schafft eine Resonatorvorrichtung, mit

einem piezoelektrischen Resonator; und

einem akustischen Reflektor bestehend aus einer Folge von übereinander angeordneten Schichten von abwechselnd niedriger und hoher akustischer Impedanz;

wobei die Dicke einer Schicht aufgrund technologischer Beschränkungen bei der Herstellung dieser Schicht abweichend von einem Viertel der akustischen Wellenlänge in dieser Schicht bei der Betriebsfrequenz eingestellt ist, und

wobei die Dicke der anderen Schicht in Abhängigkeit von der einen Schicht derart eingestellt ist, dass eine vorbestimmte Mindestgüte des akustischen Reflektors erreicht wird.

Der vorliegenden Erfindung liegt die Erkenntnis zugrunde, dass sich auch Bragg-Reflektoren realisieren lassen, die nicht der obigen Bedingung hinsichtlich der optimalen Schichtdicke genügen, und trotzdem eine hohe Reflektivität aufweisen. Wählt man für ein Schichtmaterial die Schichtdicke d ungleich $d_{opt}$, so lässt sich für das andere Schichtmaterial eine Schichtdicke finden, bei der die Reflektivität des Bragg-Reflektors, d. h., dessen Güte, maximal wird.

Gemäß einem bevorzugten Ausführungsbeispiel der vorliegenden Erfindung lassen sich hierdurch insbesondere Bragg-Reflektoren herstellen, die aus Metallschichten mit einer Dicke von $d < d_{opt}$ und aus $SiO_2$-Schichten mit einer Dicke von $d > d_{opt}$ bestehen. Hierdurch lassen sich gleichzeitig die bei der Herstellung von Schichten und die aufgrund der parasitären Kapazitäten auftretenden Probleme reduzieren oder eliminieren. Ferner ist es möglich, die Reflektoren so zu realisieren, dass minimale Temperaturkoeffizienten des Gesamtresonators erreicht werden, und insbesondere lassen sich Resonatoren realisieren, bei denen dieses Kriterium besser erfüllt ist als bei Resonatoren, welche Schichten verwenden, die eine Dicke entsprechend der optimalen Schichtdicke aufweisen.

Gegenüber den im Stand der Technik bekannten Verfahren lehrt die vorliegende Erfindung also die absichtliche Verletzung der Bedingung hinsichtlich der optimalen Schichtdicke, so dass bei gleichzeitiger Anpassung der Schichtdicke des einen Materials, bei gegebener Schichtdicke des anderen Materials, die Reflektivität des Bragg-Reflektors maximal wird. Der Vorteil der erfindungsgemäßen Vorgehensweise besteht darin, dass die so erhaltenen Schichtstapel des Reflektors technologisch einfach zu realisieren sind und somit weitere Vorteile im Zusammenhang mit der Prozeßstabilität und den Prozesskosten haben. Ein weiterer Vorteil besteht darin, dass sich gleichzeitig durch entsprechende Schichtdickenanpassungen besondere elektrische Eigenschaften, z. B. die Verminderung von parasitären Kapazitäten, sowie ein stabiles Temperaturverhalten des Dünnfilmresonators erreichen lassen.

Gemäß einem bevorzugten Ausführungsbeispiel wird die Dicke der einen Schicht gegenüber dem optimalen Wert erniedrigt, und die Dicke der anderen Schicht wird gegenüber dem optimalen Wert erhöht. Diesbezüglich wird darauf hingewiesen, dass gemäß einem weiteren Ausführungsbeispiel die eine Schicht entweder die Schicht mit niedriger oder mit akustisch hoher Impedanz ist, wobei die andere Schicht dann die Schicht mit hoher bzw. niedriger Impedanz ist.

Vorzugsweise bestehen die Schichten mit hoher akustischer Impedanz aus dem gleichen Material und ebenso bestehen die Schichten mit niedriger akustischer Impedanz aus dem gleichen Material, so dass die Bragg-Reflektoren in diesem Fall aus zwei verschiedenen Materialien hergestellt sind. Die vorliegende Erfindung ist jedoch nicht auf diese Ausgestaltung beschränkt, statt dessen können auch mehr als zwei Materialien in einem Bragg-Reflektor verwendet werden, so dass beispielsweise die Schichten mit hoher akustischer Impedanz und/oder die Schichten mit niedriger akustischer Impedanz aus unterschiedlichen Materialien hergestellt sind.

Anhand der beiliegenden Zeichnungen werden nachfolgend bevorzugte Ausführungsbeispiele der vorliegenden Erfindung näher erläutert. Es zeigen:

Fig. 1 eine im Stand der Technik bekannte Resonatorvorrichtung mit einem akustischen Reflektor mit Schichten, die eine optimale Dicke aufweisen;

Fig. 2 eine Resonatorvorrichtung gemäß einem Ausführungsbeispiel der vorliegenden Erfindung; und

Fig. 3 eine Darstellung der Isokontur-Linien der Güte des in Fig. 2 gezeigten Resonators als Funktion der Dicke der Schicht mit hoher akustischer Impedanz und der Dicke der Schicht mit niedriger akustischer Impedanz.

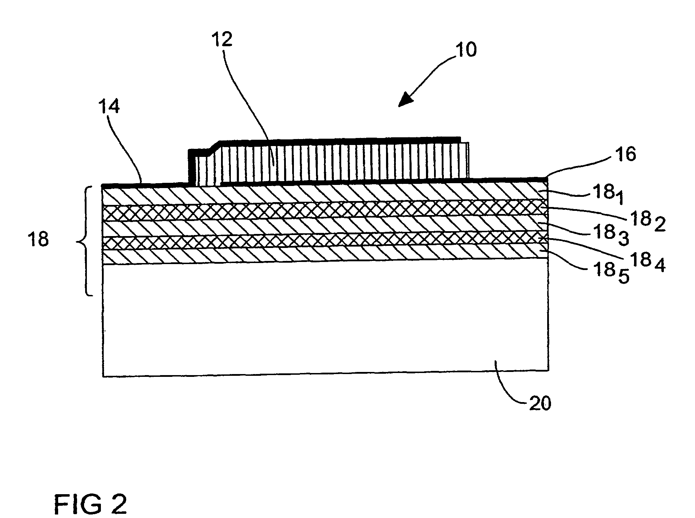

Anhand der Fig. 2 wird nachfolgend ein bevorzugtes Ausführungsbeispiel der vorliegenden Erfindung näher erläutert. Die Darstellung der Resonatorvorrichtung in Fig. 2 ist ähnlich zu der in Fig. 1, jedoch umfasst der Reflektor 18 gemäß dem Ausführungsbeispiel nur fünf Schichten $18_1$ bis $18_5$, die ferner von dem in Fig. 1 dargestellten Ausführungsbeispiel dadurch abweichen, dass deren Dicken von den optimalen Dicken der Schichten, wie sie entsprechend der obigen Bedingung (1) für diese optimale Schichtdicken bestimmt werden, abweichen.

In Fig. 2 ist ein Ausführungsbeispiel gezeigt, bei dem der Bragg-Reflektor 18 eine Schichtfolge umfasst, die aus einer $SiO_2$-Schicht $18_1$, einer Mo-Schicht $18_2$, einer $SiO_2$-Schicht $18_3$, einer Mo-Schicht $18_4$ und einer $SiO_2$-Schicht $18_5$ besteht. Die Resonanzfrequenz der Resonatoreinrichtung beträgt 900 MHz. Für die weitere Betrachtung sei, ohne Beschränkung der Allgemeinheit, als Substratmaterial Silizium und als piezoelektrisches Material 12 ZnO angenommen.

Würde man die obige Bedingung hinsichtlich der optimalen Schichtdicke zugrunde legen, so ergäbe sich für den Bragg-Reflektor 18 eine optimale Schichtdicke der $SiO_2$-Schichten, die etwa gleich der optimalen Dichte der Mo-Schichten ist und etwa 1600 nm betragen würde ($d_{opt}^{SiO2} \cong d_{opt}^{Mo} \cong 1600$ nm) . Mit Hilfe eines Mason-Modells, welches beispielsweise von K.M. Lakin, G. R. Kline, und K.T. McCarron, IEEE Trans. Microwave Theory Techniques, Band 41, Nr. 12, 1993 oder von V. M. Ristic, "Priciples of acoustic devices", Wiley (1983) beschrieben wird, wurde das elektrische Verhalten für verschiedene Oxid- bzw. Molybdändicken im Reflektor berechnet. Hierbei wurde keine Materialdämpfung verwendet, und die Substratunterseite wurde als perfekt absorbierend modelliert. Dadurch kann ein Energieverlust nur durch den Bragg-Reflektor ins Substrat stattfinden. Es kann somit die Resonatorgute als ein direktes Maß für die Güte des Bragg-Reflektors verwendet werden. Die Güte des Resonators wiederum lässt sich sehr einfach aus der Impedanzkennlinie über die Steigung der Phasenkurve berechnen (siehe K.M. Lakin, G.R. Kline, und K.T. McCarron, IEEE Trans. Microwave Theory Techniques, Band 41, Nr. 12, 1993).

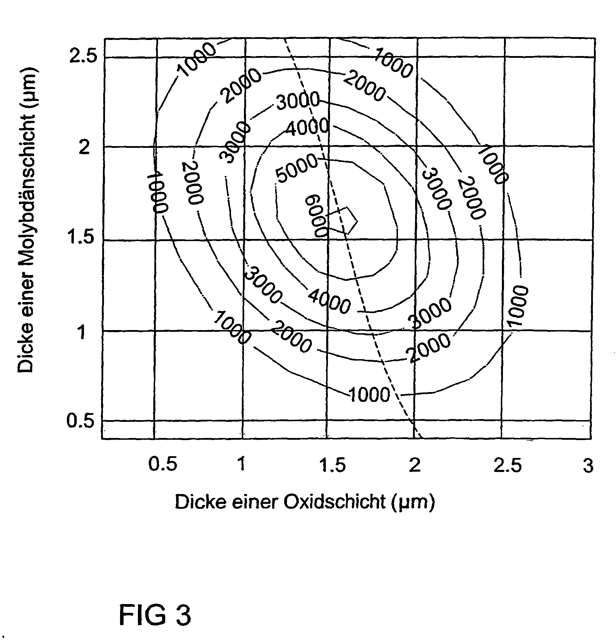

In Fig. 3 ist die Isokonturlinie der Güte eine BAW-Resonators auf einem Bragg-Reflektor dargestellt, wobei der Bragg-Reflektor aus zwei Schichten Molybdän und drei Schichten $SiO_2$ besteht. Die Güte ist als Funktion der Oxid- bzw. Molybdändicke dargestellt. Die in Fig. 2 gezeigte gestrichelte Linie stellt die optimale Schichtdickenkombination bei Vorgabe der Dicke einer Schicht, z. B. der Dicke des Molybdäns, dar.

Wie aus Fig. 2 zu erkennen ist, ergibt die maximale Güte von etwa 6200 bei den oben genannten $\lambda/4$-Schichtdicken von 1600 nm. Für gängige Filteranwendungen im Telekommunikationsbereich ist in der Regel eine Güte von 1000 bis 2000 ausreichend. Ferner können höhere Güten in der Realität im Regelfall nicht umgesetzt werden, da die Güte der Gesamtanordnung dann durch andere Verlustkanäle, wie z. B. elektrischer Verlust im Resonator, akustische Verluste durch nicht vertikale Schwingungsmoden sowie elektrische Verluste durch elektrische Parasitäten, dominiert wird.

Wie ein Blick auf die Isokonturlinie bei Q = 2000 in Fig. 2 zeigt, kann diese Güte bereits mit einer Molybdändicke von 800 nm und einer Oxiddicke von 1800 nm erreicht werden. Somit ist nur halb so viel Molybdän erforderlich, was hinsichtlich der technologischen Realisierbarkeit eine wesentliche Erleichterung darstellt. Gleichzeitig ist die $SiO_2$-Schichtdicke im Vergleich zu $\lambda/4$-Schichtdicke um mehr als 10% erhöht, was mit einer Verminderung der parasitären Kapazität zum Substrat hin verbunden ist. Eine weitere Möglichkeit, die vorliegende Erfindung umzusetzen, besteht darin, bei vorgegebener Reflektor-Güte nicht nur die Dicke der Schichten in Bezug auf prozesstechnische Randbedingungen zu optimieren, sondern auch die Anzahl der Spiegelschichten selbst zu bestimmen. Eine Berechnung analog zu der oben beschriebenen, jedoch mit drei Mo-Schichten, ergibt z. B., dass eine Reflektor-Güte von 5000 mit drei Mo-Schichten von jeweils 550 nm Dicke erreicht werden kann. Im Fall von zwei Schichten (siehe Fig. 3) wäre zum Erreichen der selben Güte die Schichtdicke der Molybdänschichten jeweils etwa 1300 nm. Im ersten Fall muss somit lediglich Molybdän mit einer Dicke von 1600 nm abgeschieden werden, während im zweiten Fall eine Abscheidung mit einer Dicke von 2600 nm notwendig ist, um einen Reflektor mit gleicher Güte zu realisieren.

Vorzugsweise wird gemäß der vorliegenden Erfindung versucht, die Dicke der Metallschichten, welche die Schichten mit hoher akustischer Impedanz darstellen zu reduzieren, wohingegen dielektrische Schichten eine erhöhte Dicke aufweisen, um so die Probleme im Zusammenhang mit der technischen Realisierung der Metallschichten und gleichzeitig die Probleme im Zusammenhang mit parasitären Kapazitäten zu reduzieren.

Bezugszeichenliste:

| | |
|---|---|
| 10 | Resonator |
| 12 | piezoelektrische Schicht |
| 14 | erste Elektrode |
| 16 | zweite Elektrode |
| 18 | Bragg-Reflektor |
| $18_1$ | Schicht mit niedriger akustischer Impedanz |
| $18_2$ | Schicht mit hoher akustischer Impedanz |
| $18_3$ | Schicht mit niedriger akustischer Impedanz |
| $18_4$ | Schicht mit hoher akustischer Impedanz |
| $18_5$ | Schicht mit niedriger akustischer Impedanz |
| $18_6$ | Schicht mit hoher akustischer Impedanz |
| $18_7$ | Schicht mit niedriger akustischer Impedanz |
| 20 | Substrat |

**Patentansprüche**

1. Resonatorvorrichtung, mit

    einem piezoelektrischen Resonator (10); und

    einem akustischen Reflektor (18) bestehend aus einer Folge von übereinander angeordneten Schichten ($18_1$ - $18_5$) von abwechselnd niedriger und hoher akustischer Impedanz;

    wobei die Dicke einer Schicht aufgrund technologischer Beschränkungen in der Herstellung dieser Schicht abweichend von einem Viertel der akustischen Wellenlänge in dieser Schicht bei der Betriebsfrequenz eingestellt ist, und
    wobei die Dicke einer anderen angenzenden Schicht in Abhängigkeit von der einen Schicht derart eingestellt ist, dass eine vorbestimmte Mindestgüte des akustischen Reflektors erreicht wird,
    wobei der die Dicke der einen Schicht gegenüber dem Viertel der Wellenlänge erniedrigt ist, und bei der die Dicke der anderen Schicht gegenüber dem Viertel der Wellenlänge erhöht ist.

2. Resonatorvorrichtung nach Anspruch 1, bei der der akustische Reflektor (18) eine Mehrzahl von Schichten ($18_2$, $18_4$) mit hoher akustischer Impedanz ist und eine Mehrzahl von Schichten ($18_1$, $18_3$, $18_5$) mit niedriger akustischer Impedanz umfasst.

3. Resonatorvorrichtung nach Anspruch 1 oder 2, bei der die Schicht ($18_2$, $18_4$) mit hoher akustischer Impedanz aus Wolfram, Platin, Molybdän oder Gold hergestellt ist und bei der die Schicht ($18_1$, $18_3$, $18_5$) mit niedriger akustischer Impedanz aus Siliziumdioxid oder Aluminium hergestellt ist.

4. Resonatorvorrichtung nach Anspruch 3, bei der die Dicke der Schicht ($18_2$, $18_4$) mit hoher akustischer Impedanz aus etwa ein Achtel der Wellenlänge in dieser Schicht bei der Betriebsfrequenz ist, und bei der die Dicke der Schicht ($18_1$, $18_3$, $18_5$) mit niedriger akustischer Impedanz gegenüber dem Viertel der Wellenlänge um etwa 10% erhöht ist.

5. Resonatorvorrichtung nach einem der Ansprüche 1 bis 4, bei der die eine Schicht die Schicht ($18_2$, $18_4$) mit hoher akustischer Impedanz ist und bei der die andere Schicht die Schicht ($18_1$, $18_3$, $18_5$) mit niedriger akustischer Impedanz ist.

6. Resonatorvorrichtung nach einem der Ansprüche 1 bis 3, bei der die eine Schicht die Schicht mit niedriger akustischer Impedanz ist, und bei der die andere Schicht die Schicht mit hoher akustischer Impedanz ist.

7. Resonatorvorrichtung nach einem der Ansprüche 1 bis 6, mit einem Substrat 20, wobei der akustische Reflektor (18) zwischen dem Substrat (20) und dem piezoelektrischen Resonator (10) angeordnet ist.

8. Resonatorvorrichtung nach Anspruch 7, bei der der piezoelektrische Resonator (10) aus ZnO oder AlN hergestellt ist, und bei der das Substrat (20) aus Silizium hergestellt ist.

9. Resonatorvorrichtung nach einem der Ansprüche 1 bis 8 bei der der piezoelektrische Resonator ein BAW-Resonator ist.

**Claims**

1. Resonator apparatus comprising

    a piezoelectric resonator (10); and

    an acoustic reflector (18) comprising a sequence of stacked layers ($18_1$ - $18_5$) having alternating low and high acoustic impedance;

    wherein the thickness of one layer is set different from a quarter of the acoustic wavelength in this layer at the operating frequency due to technological limitations in the manufacturing of this layer, and

wherein the thickness of another adjoining layer is set dependent from the one layer, such that a predetermined minimum quality of the acoustic reflector is attained,

wherein the thickness of the one layer is decreased relative to the quarter of the wavelength, and wherein the thickness of the other layer is increased relative to the quarter of the wavelength.

2. Resonator apparatus according to claim 1, wherein the acoustic reflector (18) is a plurality of layers ($18_2$, $18_4$) having a high acoustic impedance and comprises a plurality of layers ($18_1$, $18_3$, $18_5$) having a low acoustic impedance.

3. Resonator apparatus according to claim 1 or 2, wherein the layer ($18_2$, $18_4$) having a high acoustic impedance is made of tungsten, platinum, molybdenum or gold, and wherein the layer ($18_1$, $18_3$, $18_5$) having a low acoustic impedance is made of silicon dioxide or aluminum.

4. Resonator apparatus according to claim 3, wherein the thickness of the layer ($18_2$, $18_4$) having a high acoustic impedance is of approximately one eighth of the wavelength in this layer at the operating frequency, and wherein the thickness of the layer ($18_1$, $18_3$, $18_5$) having a low acoustic impedance is increased by approximately 10 % relative to the quarter of the wavelength.

5. Resonator apparatus according to any of the claims 1 to 4, wherein the one layer is the layer ($18_2$, $18_4$) having a high acoustic impedance and wherein the other layer is the layer ($18_1$, $18_3$, $18_5$) having a low acoustic impedance.

6. Resonator apparatus according to any of the claims 1 to 3, wherein the one layer is the layer having a low acoustic impedance, and wherein the other layer is the layer having a high acoustic impedance.

7. Resonator apparatus according to any of the claims 1 to 6 comprising a substrate (20), wherein the acoustic reflector (18) is arranged between the substrate (20) and the piezoelectric resonator (10).

8. Resonator apparatus according to claim 7, wherein the piezoelectric resonator (10) is made of ZnO or AlN, and wherein the substrate (20) is made of silicon.

9. Resonator apparatus according to any of the claims 1 to 8, wherein the piezoelectric resonator is a BAW resonator.

**Revendications**

1. Dispositif résonateur comprenant

un résonateur (10) piézoélectrique ; et
un réflecteur (18) acoustique constitué d'une succession de couches ($18_1$ à $18_5$) superposées d'impédance acoustique alternativement petite et grande ;
l'épaisseur d'une couche étant réglée en raison de limitations technologiques dans la fabrication de cette couche en s'écartant d'un quart des longueurs d'onde acoustique dans cette couche à la fréquence de fonctionnement, et l'épaisseur d'une autre couche voisine étant réglée en fonction de celle de la couche, de façon à obtenir un facteur de qualité déterminé à l'avance du réflecteur acoustique,

dans lequel l'épaisseur de la couche est diminuée par rapport au quart de la longueur d'onde, et dans lequel l'épaisseur de l'autre couche est augmentée par rapport au quart de la longueur d'onde.

2. Dispositif résonateur suivant la revendication 1, dans lequel le réflecteur (18) acoustique est une pluralité de couches ($18_2$, $18_4$) de grande impédance acoustique et une pluralité de couches ($18_1$, $18_3$, $18_5$) de petite impédance acoustique.

3. Dispositif résonateur suivant la revendication 1 ou 2, dans lequel la couche ($18_2$, $18_4$) de grande impédance acoustique est en tungstène, en platine, en molybdène ou en or, et la couche ($18_1$, $18_3$, $18_5$) de petite impédance acoustique est en dioxyde de silicium ou en aluminium.

4. Dispositif résonateur suivant la revendication 3, dans lequel l'épaisseur de la couche ($18_2$, $18_4$) de grande impédance acoustique est d'environ un huitième de la longueur d'onde dans cette couche à la fréquence de fonctionnement, et dans lequel l'épaisseur de la couche ($18_1$, $18_3$, $18_5$) de petite impédance acoustique est augmentée par rapport au quart de la longueur d'onde d'environ 10 %.

5. Dispositif résonateur suivant l'une des revendications 1 à 4, dans lequel la couche est la couche ($18_2$, $18_4$) de grande impédance acoustique, et dans lequel l'autre couche est la couche ($18_1$, $18_3$, $18_5$) de petite impédance acoustique.

6. Dispositif résonateur suivant l'une des revendications 1 à 3, dans lequel la couche est la couche de petite impédance acoustique, et dans lequel l'autre couche est la couche de grande impédance acoustique.

**7.** Dispositif résonateur suivant l'une des revendications 1 à 6, comprenant un substrat (20), le réflecteur (18) acoustique étant disposé entre le substrat (20) et le résonateur (10) piézoélectrique.

**8.** Dispositif résonateur suivant la revendication 7, dans lequel le résonateur (10) piézoélectrique est en ZnO ou en AIN, et dans lequel le substrat (20) est en silicium.

**9.** Dispositif résonateur suivant l'une des revendications 1 à 8, dans lequel le résonateur piézoélectrique est un résonateur d'onde acoustique en volume.

FIG 1

FIG 2

FIG 3